# EUROPEAN PATENT APPLICATION

(11) **EP 4 564 594 A1**
(43) Date of publication of application: **04.06.2025**
(21) Application number: 22952757.7
(22) Date of filing: 18.10.2022
(51) Int. Cl.: H01P 7/08, H01P 7/00, H01Q 1/38, H01Q 1/48, B07C 5/344

(54) **OPEN STUB RESONATOR, AND METHOD FOR SCREENING FINISHED PCB ANTENNA BOARD**

(30) Priority: 26.07.2022 CN 202210882545
(71) Applicant: Guangzhou Termbray Electronics, Guangzhou, Guangdong 510555 (CN)
(72) Inventor: CHANG, Kuo Hin, Guangzhou, Guangdong 510555 (CN); AKMJ, Hayrat, Guangzhou, Guangdong 510555 (CN); NILS, Kirkeby, Guangzhou, Guangdong 510555 (CN)
(74) Representative: Herrero & Asociados, S.L.
(86) International application number: PCT/CN2022/125900
(87) International publication number: WO 2024/021317

(57) **Abstract**

The present invention relates to an open-circuited stub resonator and a method for screening finished antenna PCBs. The open-circuited stub resonator includes a rectangular shielding ring (1), an open-circuited stub (2) in the rectangular shielding ring, and a transverse stub (3) perpendicularly connected to a lower end of the open-circuited stub. The rectangular shielding ring has two long edges and two short edges. The two long edges include an upper long edge (11) and a lower long edge (12). An upper end of the open-circuited stub is not connected to the upper long edge of the rectangular shielding ring. The transverse stub has a first terminal (31) and a second terminal (32). The first terminal is a signal input terminal, and the second terminal is a signal output terminal. The length of the open-circuited stub is (2*N* + 1) * λ/4), where *N* ∈ 0,1,2,3......, and λ is a wavelength corresponding to a working frequency of a resonance point to be measured. The open-circuited stub resonator is disposed at a periphery of the finished antenna PCB. The method for screening the finished antenna PCBs makes up for the deficiency in the prior art that only the antenna size is measured to screen the antenna PCBs.

## Description

### TECHNICAL FIELD

The present invention relates to the field of resonators, in particular to an open-circuited stub resonator and a method for screening finished antenna PCBs.

### BACKGROUND

The existing 1/4 wavelength resonator is susceptible to external interference and prone to distortion, making it difficult to clearly read resonance points.

In addition, the current method for shipping or determining the quality of antenna boards in PCB factories is to measure the sizes of antennas, transmission lines, etc. at the positions designated by the customers. As long as the measured data is within the tolerance range specified by the customer, it is determined that the antenna boards are qualified and can be shipped. However, the factors that affect the antenna performance are not only limited to the antenna size, but also include other various factors such as a dielectric constant, copper foil roughness, copper thickness, dielectric loss angle tangent, dielectric thickness, and contact corrosion, all of which can lead to changes in antenna performance. In the case that the customer has strict requirements for resonance points of antennas (e.g., narrowband antennas of +/-0.2 GHz or +/-0.4 GHz), there is no obvious help for strict size control.

### SUMMARY

In view of this, it is therefore an object of the present invention to provide an open-circuited stub resonator and a method for testing the performance of finished antenna PCBs, which is free from the aforesaid drawbacks of the prior art. The provided open-circuited stub resonator in the present invention is not easily affected by external interference and is less prone to distortion. Resonance points can be clearly read. The open-circuited stub resonator disposed on the finished antenna PCB can be used to test the performance of the antenna PCBs and thus screen quality of the antenna PCBs, which compensates the screening method in the prior art that only the antenna size is measured to screen the antenna PCBs.

A first aspect of the present invention provides an open-circuited stub resonator. The open-circuited stub resonator is made of a conductive material, which includes a rectangular shielding ring, an open-circuited stub in the rectangular shielding ring, and a transverse stub perpendicularly connected to a lower end of the open-circuited stub. The rectangular shielding ring has two long edges and two short edges. The two long edges include an upper long edge and a lower long edge. An upper end of the open-circuited stub is not connected to the upper long edge of the rectangular shielding ring. The transverse stub has a first terminal and a second terminal. The first terminal is a signal input terminal, and the second terminal is a signal output terminal. The length of the open-circuited stub is *(2N +* 1) * λ/4), where *N* ∈ (0 U N+), and λ is a wavelength corresponding to a working frequency of a resonance point to be measured, N₊ is a set of positive integers, namely the value of N is 0 or one of all the positive integers.

According to the open-circuited stub resonator provided in the present invention, the open-circuited stub with the length being an odd multiple of the one-quarter wavelength (the wavelength corresponding to the working frequency of the resonance point that needs to be measured) is perpendicularly connected to the transverse stub, the rectangular shielding ring is grounded, and the upper end of the open-circuited stub is not connected to the upper long edge of the rectangular shielding ring, namely the open-circuited stub is spaced apart the upper long edge of the rectangular shielding ring. During operation, a signal is input from the first terminal of the transverse stub, an electric field distribution signal with a frequency corresponding to an odd multiple of the one-quarter, three-quarter, or five-quarter wavelength of the stub is radiated out from the upper end of the stub, and signals with frequencies corresponding to other wavelengths are output from the second terminal of the transverse stub, which results in a particularly large insertion loss between the first terminal and the second terminal of the transverse stub. The stub plays the role of a quarter-wavelength antenna, thus forming an open-circuited stub resonator, which is not easily affected by external interference and is less prone to distortion, so that the resonance point can be clearly read.

Specifically, the distance between the upper end of the open-circuited stub and the upper long edge cannot be too short, otherwise, the resonance point will be affected. The distance between the transverse stub and the lower long edge also cannot be too short, as impedance mismatch will occur to cause the resonance point to be unclear. The present inventor has found through a large number of experiments that it is appropriate to set the distance between the upper end of the open-circuited stub and the upper long edge, and the distance between the transverse stub and the lower long edge in a range from 20 to 50 mil, with the ratio of the distance between the upper end of the open-circuited stub and the upper long edge to the distance between the transverse stub and the lower long edge within 1 : (0.8-1.2). This is conducive to taking into account both the resonance point and the impedance match.

In particular, each of the two short edges of the rectangular shielding ring is provided with a recess corresponding to the transverse stub, the first terminal and the second terminal of the transverse stub are embedded into the respective recess, a gap is respectively formed between the first terminal of the transverse stub and the corresponding recess and between the second terminal of the transverse stub and the corresponding recess. Such configuration allows the first terminal and the second terminal to be signal terminals for receiving and outputting signals.

Further, to facilitate the first terminal and the second terminal to be embedded into the respective recess, a narrowed portion is formed at an end of the first terminal and the second terminal of the transverse stub that is embedded into the respective recess, with the width of the narrowed portion less than the width of the main portion of the transverse stub. In addition, an arc transition portion is disposed between the narrowed portions and the main portion of the transverse stub, and the recess is provided with a chamfer corresponding to the arc transition portion, which ensures that the formed gap has uniform width.

In order to ensure that the signal can be measured and the impedance of the signal line is consistent, the gap cannot be too large or too small. Too small gap makes it difficult for production, so the gap cannot be too small. The width of the gap is preferably in a range from 3.2 to 4.8 mil.

One or two open-circuited stubs may be specifically provided according to the present invention. To form a resonator with an odd multiple of the one-quarter wavelength, the one open-circuited stub is disposed in a middle of the transverse stub in a case that only one open-circuited stub is provided, while the two open-circuited stubs are symmetrically disposed on two sides of the transverse stub respectively in a case that two open-circuited stubs are provided.

Further, the width of each short edge of the rectangular shielding ring is greater than the width of each long edge, where the ratio of the width of the short edge to the width of the long edge is (1.2-2.0): 1, which facilitates to place a probe of a device for measuring the resonance point,.

Another aspect of the present invention provides a finished antenna PCB, having a first surface and a second surface, where the second surface is a grounding surface, a periphery of the first surface of the finished antenna PCB is provided with the open-circuited stub resonator in any case mentioned above for testing performance of the finished antenna PCB, and the rectangular shielding ring of the open-circuited stub resonator is connected to the second surface.

In particular, the open-circuited stub resonator and a conductive layer on the finished antenna PCB are formed in one step by same process.

With the open-circuited stub resonator disposed at the periphery of the finished antenna PCB and formed in one step by the same process, such as using the same copper wire, together with the conductive layer on the finished antenna PCB, it ensures accurate test for performance of the finished antenna PCB without affecting the performance of the finished antenna PCB itself.

Further, the finished antenna PCB may include a plurality of unit boards. To accurately measure the resonance point of the finished antenna PCB, asymmetric positions of at least two sides of the unit board of the finished antenna PCB are each provided with one open-circuited stub resonator.

A third aspect of the present invention provides a method for screening the finished antenna PCBs. The method for screening the finished antenna PCB specifically includes: in the same cycle of manufacturing finished antenna PCBs, manufacturing multiple batches of finished antenna PCBs. The method for testing performance of the finished antenna PCBs specifically includes the following steps:
S1: measuring resonance points of a first batch of finished antenna PCBs;
S2: determining a mid-value of all measured resonance points data; and
S3: screening other batches of PCBs by the mid-value.

The step S3 may specifically include: based on the mid-value, setting a screening threshold for qualified PCBs, measuring resonance points of the other batches of finished antenna PCBs, if the measured resonance points are within the threshold, determining that the measured finished antenna PCBs are qualified, otherwise, determining that the measured finished antenna PCBs are unqualified.

Further, to take into account both the accuracy and quantity of qualified antenna PCBs, the threshold is preferably within ± 20%.

To further improve the accuracy of screening the qualified antenna PCBs, after the step S3, the following step may be further included:
S4: after screening of each batch of PCBs is completed, returning to the step S2 for iterating the mid-value to determine a new mid-value.

The specific method for iterating the mid-value to determine the new mid-value in the step S4 includes: mixing the measured resonance points of each batch of finished antenna PCBs with the previously measured resonance points of multiple batches of finished antenna PCBs, then redetermining a new mid-value, and screening the next batch of finished antenna PCBs by the new mid-values.

For testing the finished antenna PCBs manufactured in the same cycle, the steps S2 to S4 are repeated until screening of all batches of finished antenna PCBs is completed, which can more accurately screen out more qualified finished antenna PCBs.

As the performance of the fabricated finished antenna PCBs is different in different cycles of manufacturing the antenna PCBs, in another cycle of manufacturing the finished antenna PCBs, started from the step S1, the steps S2 to S4 are conducted cyclically.

The specific method for measuring resonance points in the step S1 may include: embedding a probe of a measuring device together with the first terminal and the second terminal of the transverse stub into the recess in each two short edge of the rectangular shielding ring respectively for connection, and measuring the resonance points of the finished antenna PCBs by the measuring device.

Compared with the prior art, the present invention has the following beneficial effects.

The open-circuited stub resonator provided in the present invention is not easily affected by external interference and is less prone to distortion. The resonance points thus can be clearly read. With the open-circuited stub resonator disposed on the finished antenna PCB, the performance of the finished antenna PCBs can be tested to screen the antenna PCBs, such method makes up for the deficiency in the prior art that only the antenna size is measured to determine the quality of the antenna boards shipped by the PCB factory to result in low yield for the client side. Moreover, the antenna boards with more stable radio-frequency performance can be provided for the customer, thus greatly reducing unnecessary surface mounting costs for the customer.

### BRIEF DESCRIPTION OF THE DRAWINGS

FIG. 1 is a schematic structural diagram of a resonator with one open-circuited stub;
FIG. 2 is a schematic structural diagram of a resonator with two open-circuited stubs;
FIG. 3 is a schematic enlarged structural view of a part C in FIG. 1 and FIG. 2;
FIG. 4 is a resonance curve of Embodiment 1 and Embodiment 2;
FIG. 5 is a schematic structural diagram of an open-circuited stub resonator on a finished antenna PCB;
FIG. 6 is a schematic flowchart of Embodiment 4 of a method for screening the finished antenna PCBs in the present invention; and
FIG. 7 is a schematic flowchart of Embodiment 5 of a method for screening the finished antenna PCBs in the present invention.

### DETAILED DESCRIPTION OF THE EMBODIMENTS

The accompanying drawings of the present invention are only for illustrative purposes and cannot be construed as limiting the present invention. To better illustrate the following embodiments, some components in the accompanying drawings may be omitted, enlarged, or reduced, and do not represent the actual size of the product. For those skilled in the art, it can be understood that some well-known structures and their descriptions may be omitted in the accompanying drawings.

### Embodiment 1

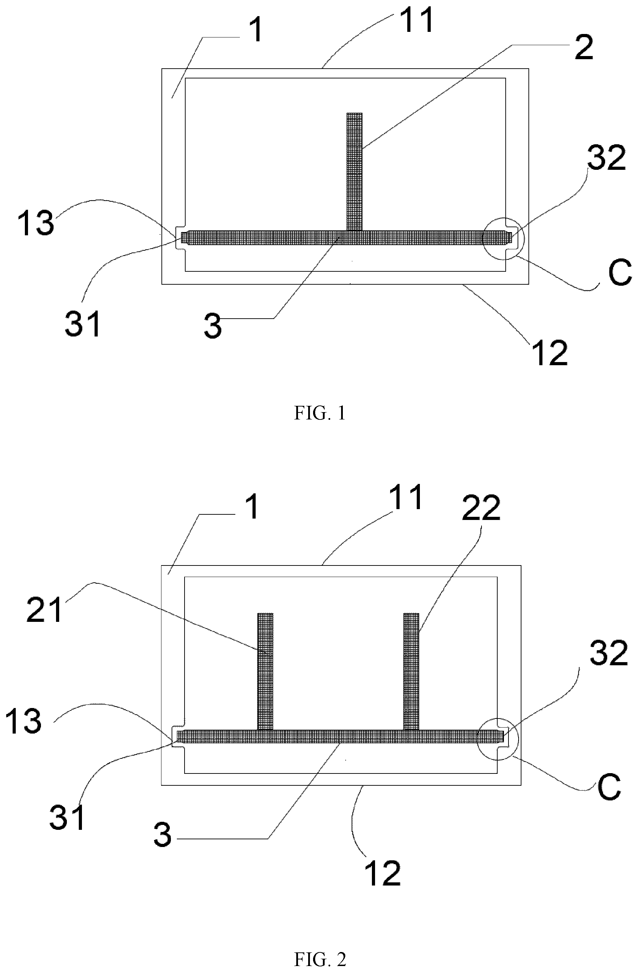

FIG. 1 provides an open-circuited stub resonator according to an embodiment of the present invention. The open-circuited stub resonator in this embodiment includes a rectangular shielding ring 1, an open-circuited stub 2 in the rectangular shielding ring, and a transverse stub 3 perpendicularly connected to a lower end of the open-circuited stub. The rectangular shielding ring 1 has two long edges and two short edges. The two long edges include an upper long edge 11 and a lower long edge 12. An upper end of the open-circuited stub 3 is not connected to the upper long edge 11 of the rectangular shielding ring. A distance between the upper end of the open-circuited stub and the upper long edge of the rectangular shielding ring is 38 mil. A distance between the transverse stub 3 and the lower long edge 12 of the rectangular shielding ring is 30 mil. The open-circuited stub 2 is disposed in the middle portion of the transverse stub 3. The transverse stub 3 has a first terminal 31 and a second terminal 32. The first terminal 31 is a signal input terminal, and the second terminal 32 is a signal output terminal. The length of the open-circuited stub is the five-quarter wavelength of a working frequency (a working frequency of a resonance point that needs to be measured is 77 GHz). In this embodiment, the material has a dielectric constant of 3.16 and a thickness of 0.127 mm, and the open-circuited stub has a length of 3 mm.

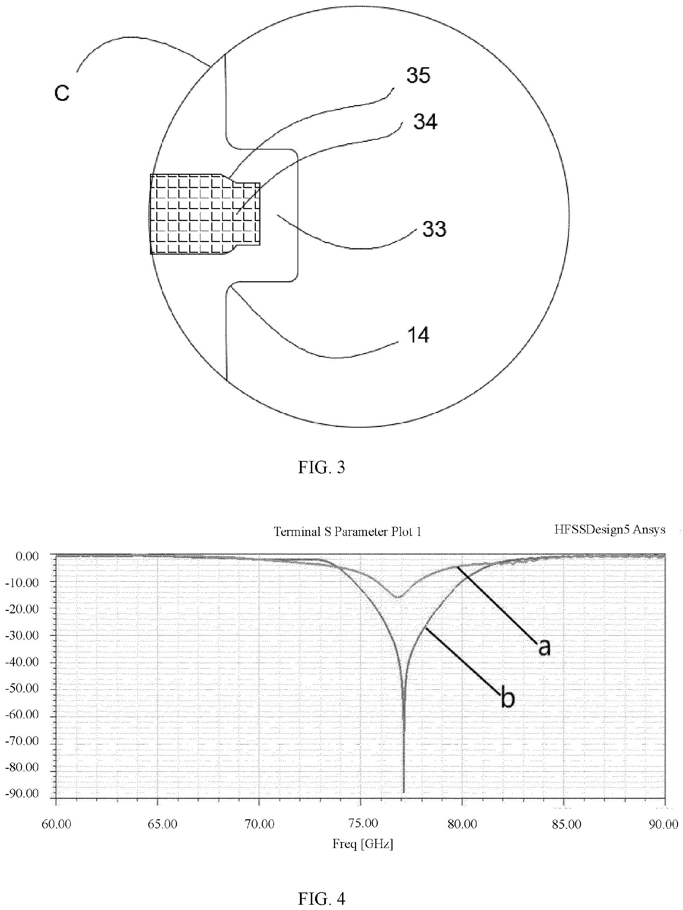

Specifically, the two short edges of the rectangular shielding ring 1 that correspond to the transverse stub are each provided with a recess 13, the first terminal 31 and the second terminal 32 of the transverse stub are embedded into the respective recess 13. Referring to FIG. 3, a gap 33 is respectively formed between the first terminal 31 of the transverse stub and the corresponding recess 13 and between the second terminal 32 of the transverse stub and the corresponding recess, and the first terminal and the second terminal are signal terminals for receiving and outputting signals.

To facilitate the first terminal 31 and the second terminal 32 to be embedded into the respective recess 13, parts of the first terminal 31 and the second terminal 32 of the transverse stub that are embedded into the recesses 13 each form a narrowed portion 34, with the width of the narrowed portion 34 less than the width of the main portion of the transverse stub. An arc transition portion 35 is formed between each narrowed portion 34 and the main portion of the transverse stub 3. The recess corresponding to the arc transition portion is provided with a chamfer 14 to ensure that the formed gap 33 has uniform width.

Particularly, the width of the gap 33 in this embodiment is 4 mil, which ensures that the signal can be measured and the impedance of a signal line is consistent, and further makes it easy to manufacture.

Further, the two short edges of the rectangular shielding ring are both wider than the two long edges, which facilitates placing a probe of a device for measuring the resonance point.

### Embodiment 2

FIG.2 provides an open-circuited stub resonator according to another embodiment of the present invention. The open-circuited stub resonator in this embodiment includes a rectangular shielding ring 1, two open-circuited stubs 21, 22 in the rectangular shielding ring, and a transverse stub 3 perpendicularly connected to lower ends of the open-circuited stub 21 and 22. The rectangular shielding ring 1 has two long edges and two short edges. The two long edges include an upper long edge 11 and a lower long edge 12. Upper ends of the two open-circuited stubs are both not connected to the upper long edge 11 of the rectangular shielding ring. A distance between each of the upper ends of the two open-circuited stubs 21 and 22 and the upper long edge 11 of the rectangular shielding ring is 38 mil. A distance between the transverse stub 3 and the lower long edge 12 of the rectangular shielding ring is 40 mil. The transverse stub 3 has a first terminal 31 and a second terminal 32. The first terminal 31 is a signal input terminal, and the second terminal 32 is a signal output terminal. The length of the open-circuited stub is the five-quarter wavelength of a working frequency (a working frequency of a resonance point that needs to be measured is 77 GHz). In this embodiment, the material has a dielectric constant of 3.16 and a thickness of 0.127 mm, and the open-circuited stub has a length of 3 mm.

Specifically, the two short edges of the rectangular shielding ring 1 that correspond to the transverse stub are each provided with a recess 13, the first terminal 31 and the second terminal 32 of the transverse stub are embedded into the respective recess 13. Referring to FIG. 3, a gap 33 is respectively formed between the first terminal 31 of the transverse stub and the corresponding recess 13 and between the second terminal 32 of the transverse stub and the corresponding recess, and the first terminal and the second terminal are signal terminals for receiving and outputting signals.

To facilitate the first terminal 31 and the second terminal 32 to be embedded into the respective recess 13, parts of the first terminal 31 and the second terminal 32 of the transverse stub that are embedded into the recesses 13 each form a narrowed portion 34, with the width of the narrowed portion 34 less than the width of the main portion of the transverse stub. An arc transition portion 35 is formed between the narrowed portion 34 and the main portion of the transverse stub 3. The recess corresponding to the arc transition portion is provided with a chamfer 14 to ensure that the formed gap 33 has uniform width.

Specifically, the width of the gap 33 in this embodiment is 4.2 mil, which ensures that the signal can be measured and the impedance of a signal line is consistent, and makes it easy to manufacture.

Further, to facilitate placing a probe of a device for measuring the resonance point, the two short edges of the rectangular shielding ring are both wider than the two long edges.

During operation of the open-circuited stub resonators in Embodiment 1 and Embodiment 2, a signal is input from the first terminal 31 of the transverse stub, an electric field distribution signal with a frequency corresponding to an odd multiple of the one-quarter, three-quarter, or five-quarter wavelength of the stub is radiated out from the upper end of the stub, and signals with frequencies corresponding to other wavelengths are thus output from the second terminal 32 of the transverse stub, resulting in a particularly large insertion loss between the first terminal 31 and the second terminal 32 of the transverse stub.

Test results of testing the open-circuited stub resonators in Embodiment 1 and Embodiment 2 are shown in FIG. 4, where curve "a" shows the resonance curve of Embodiment 1, and curve "b" shows the resonance curve of Embodiment 2.

It can be seen from FIG. 4 that the resonance point of the resonator with two open-circuited stubs in Embodiment 2 is more obvious, and the value of the resonance point can be seen more easily.

### Embodiment 3

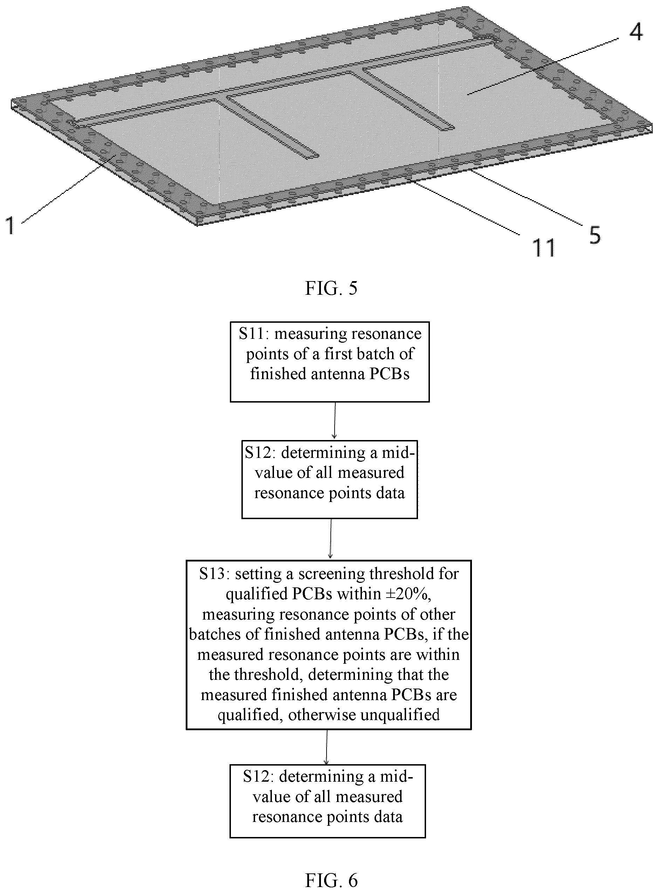

This embodiment provides a finished antenna PCB. With the same manufacture process as an antenna PCB, eight open-circuited stub resonators in Embodiment 2 are disposed at a periphery of the antenna PCB with four unit boards, and asymmetric positions of two sides of each unit board are each provided with one open-circuited stub resonator to obtain the finished antenna PCB with the open-circuited stub resonators. As shown in FIG. 5, the finished antenna PCB has a first surface 4 and a second surface 5, where the second surface 5 is a grounding surface, the above open-circuited stub resonator is disposed at a periphery of the first surface 4 of the finished antenna PCB to test the performance of the finished antenna PCB. The rectangular shielding ring 1 of the open-circuited stub resonator further includes a shielding hole 11, and the rectangular shielding ring 1 is connected to the grounding surface through the shielding hole 11 to shield a signal.

### Embodiment 4

FIG. 6 provides a method for screening the finished antenna PCBs according to an embodiment of the present invention. In the same cycle of manufacturing the finished antenna PCBs (antenna boards are 77 GHz radar boards), multiple batches of finished antenna PCBs (i.e., multiple batches of finished antenna PCBs with open-circuited stub resonators) are manufactured. The method for testing the performance of the finished antenna PCBs specifically includes the following steps.

In S11, resonance points of a first batch of finished antenna PCBs are measured. Specifically, a vector network analyzer (VNA) is used as the measuring device in this embodiment, a probe of the measuring device together with the first terminal and the second terminal of the transverse stub are embedded into the recesses in the two short edges of the rectangular shielding ring respectively for connection, and the resonance points of the finished antenna PCBs are measured by the measuring device.

In S12, a mid-value of the measured resonance point data is determined.

In S13, other batches of finished antenna PCBs are screened by the obtained mid-value. Specifically, based on the mid-value, a screening threshold for qualified PCBs is set, where the threshold is within ±20%. Resonance points of the other batches of finished antenna PCBs are measured (by the same method as S11), if the measured resonance points are within the threshold, it is determined that the measured finished antenna PCBs are qualified, otherwise, it is determined that the measured finished antenna PCBs are unqualified.

### Embodiment 5

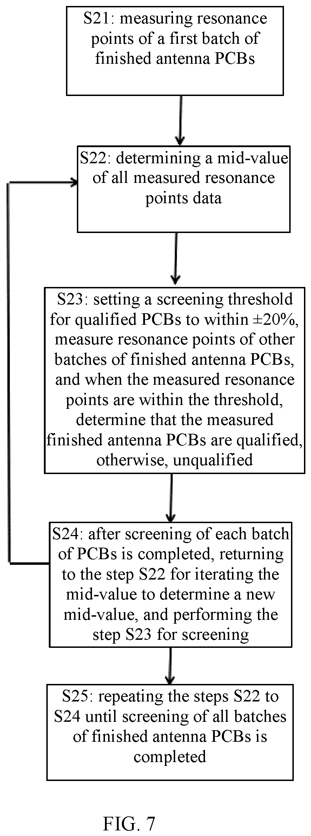

FIG. 7 provides a method for screening finished antenna PCBs according to another embodiment. In the same cycle of manufacturing finished antenna PCBs (antenna boards are 77 GHz radar boards), multiple batches of finished antenna PCBs (i.e., multiple batches of finished antenna PCBs with open-circuited stub resonators) are manufacured. The method for testing the performance of the finished antenna PCBs specifically includes the following steps.

In S21, resonance points of a first batch of finished antenna PCBs are measured. Specifically, a VNA is used as the measuring device in this embodiment, a probe of the measuring device together with the first terminal and the second terminal of the transverse stub are embedded into the recesses in the two short edges of the rectangular shielding ring respectively for connection, and the resonance points of the finished antenna PCBs are measured by the measuring device.

In S22, a mid-value of the measured resonance point data is determined.

In S23, other batches of finished antenna PCBs are screened by the obtained mid-value. Based on the mid-value, a screening threshold for qualified PCBs is set, where the threshold is within ±20%. Resonance points of the other batches of finished antenna PCBs are measured, if the measured resonance points are within the threshold, it is determined that the measured finished antenna PCBs are qualified, otherwise, it is determined that the measured finished antenna PCBs are unqualified.

In S24, after screening of each batch of PCBs is completed, operation of returning to the step S2 is performed for iterating the mid-value to determine a new mid-value. Specifically, the measured resonance points of the first batch of finished antenna PCBs are mixed with the previously measured resonance points of the other batches of finished antenna PCBs to determine the new mid-value, and the next batch of finished antenna PCBs are screened by using the new mid-value.

In S25, the steps S22 to S24 are repeated until screening of all batches of finished antenna PCBs is completed.

### Embodiment 6

In another cycle of manufacturing finished antenna PCBs, the step S21 in Embodiment 5 is started again, and the steps S22 to S25 are conducted cyclically.

### Comparative example 1

Antenna PCBs are tested and screened by a conventional method.

Data of qualified antenna PCBs screened by methods in Comparative example 1 and Embodiment 4, and data of antenna PCBs that meet customer requirements are as shown in Table 1 and Table 2 as follows.

**Table 1: Data of qualified antenna PCBs screened by conventional method and data of antenna PCBs that meet customer requirements**

| Customer requirements for frequency tolerance of narrowband antenna | Size tolerance (conventional method) | | | | |
|---|---|---|---|---|---|
| | +/-1mil | +/-0.8mil | +/-0.6mil | +/-0.4mil | +/-0.2mil |
| +/-1GHz | 100%(13/13) | 100%(11/11) | 100%(11/11) | 100%(9/9) | 0%(0/0) |
| +/-0.8GHz | 100%(13/13) | 100%(11/11) | 100%(11/11) | 100%(9/9) | 0%(0/0) |
| +/-0.6GHz | 100%(13/13) | 100%(11/11) | 100%(11/11) | 100%(9/9) | 0%(0/0) |
| +/-0.4GHz | 85%(11/13) | 82%(9/11) | 82%(9/11) | 78%(7/9) | 0%(0/0) |
| +/-0.2GHz | 31%(4/13) | 18%(2/11) | 18%(2/11) | 22%(2/9) | 0%(0/0) |

**Table 2: Data of qualified antenna PCBs screened in Embodiment 4 and data of antenna PCBs that meet customer requirements**

| Customer requirements for frequency tolerance of narrowband antenna | Resonance point tolerance (method in the present invention) | | | | |
|---|---|---|---|---|---|
| | +/-1GHz | +/-0.8GHz | +/-0.6GHZ | +/-0.4GHZ | +/-0.2GHZ |
| +/-1GHz | 100%(13/13) | 100%(13/13) | 100%(13/13) | 100%(11/11) | 100%(3/3) |
| +/-0.8GHz | 100%(13/13) | 100%(13/13) | 100%(13/13) | 100%(11/11) | 100%(3/3) |
| +/-0.6GHz | 100%(13/13) | 100%(13/13) | 100%(13/13) | 100%(11/11) | 100%(3/3) |
| +/-0.4GHz | 85%(11/13) | 85%(11/13) | 85%(11/13) | 82%(9/11) | 100%(3/3) |
| +/-0.2GHz | 31%(4/13) | 31%(4/13) | 31%(4/13) | 36%(2/9) | 67%(2/3) |

It can be seen from Table 1 and Table 2 that when the customer has stricter requirements for resonance points of antennas (e.g., some narrowband antennas of +/-0.2 GHz or +/-0.4 GHz), the conventional method (by size measurement) has no obvious improvement for size control. However, according to the method provided in the present invention, the ex-factory yield of the antenna PCBs can be significantly increased by reducing the tolerance of the open-circuited stub resonator, and the antenna boards with more stable radio-frequency performance can be provided for the customer, thus greatly reducing unnecessary mounting costs for the customer.

Apparently, the above embodiments of the present invention are only examples provided to clearly illustrate the technical solutions of the present invention, and are not limitations on the specific implementations of the present invention. Any modifications, equivalent replacements, improvements, etc. made within the spirit and principle of the claims of the present invention shall be included within the scope of protection of the claims of the present invention.

## Claims

1. An open-circuited stub resonator, which is made of a conductive material, comprising:
a rectangular shielding ring, which has two long edges including an upper long edge and a lower long edge, and two short edges;
an open-circuited stub in the rectangular shielding ring, wherein an upper end of the open-circuited stub is not connected to the upper long edge of the rectangular shielding ring; and
a transverse stub perpendicularly connected to a lower end of the open-circuited stub, which has a first terminal being a signal input terminal and a second terminal being a signal output terminal,
wherein the length of the open-circuited stub is *(2N +* 1) * λ/4), where *N* ∈ (0 U N+), and λ is a wavelength corresponding to a working frequency of a resonance point to be measured.

2. The open-circuited stub resonator according to claim 1, wherein each of the two short edges of the rectangular shielding ring is provided with a recess corresponding to the transverse stub, the first terminal and the second terminal of the transverse stub are embedded into the respective recess, and a gap is respectively formed between the first terminal of the transverse stub and the corresponding recess and between the second terminal of the transverse stub and the corresponding recess.

3. The open-circuited stub resonator according to claim 1, wherein a narrowed portion is respectively formed at an end of the first terminal and the second terminal of the transverse stub that is embedded into the respective recess, with a width of the narrowed portion less than a width of a main portion of the transverse stub, an arc transition portion is disposed between the narrowed portion and the main portion of the transverse stub, and the recess is provided with a chamfer corresponding to the arc transition portion to make the gap formed having uniform width.

4. The open-circuited stub resonator according to claim 3, wherein a width of the gap is in a range from 3.2 to 4.8 mil.

5. The open-circuited stub resonator according to any one of claims 1 to 4, wherein one or two open-circuited stubs are provided, in a case of one open-circuited stub, the one open-circuited stub is disposed in a middle portion of the transverse stub; and in a case of two open-circuited stubs, the two open-circuited stubs are symmetrically disposed on two sides of the transverse stub respectively.

6. A finished antenna PCB, having a first surface and a second surface, wherein the second surface is a grounding surface, a periphery of the first surface is provided with the open-circuited stub resonator according to any one of claims 1 to 5 for testing performance of the finished antenna PCB, with the rectangular shielding ring of the open-circuited stub resonator connected to the second surface.

7. The finished antenna PCB according to claim 6, wherein the open-circuited stub resonator and a conductive layer on the antenna PCB are formed in one step by same process.

8. The finished antenna PCB according to claim 6, wherein the antenna PCB is provided with a plurality of unit boards, and asymmetric positions of at least two sides of each of the unit boards are each provided with one open-circuited stub resonator.

9. A method for screening the finished antenna PCBs according to any one of claims 6 to 8, wherein in the method, in a same cycle of manufacturing finished antenna PCBs, multiple batches of finished antenna PCBs are manufactured, steps of testing performance of the finished antenna PCBs comprise:
S1: measuring resonance points of a first batch of finished antenna PCBs;
S2: determining a mid-value of all measured resonance points data; and
S3: screening other batches of PCBs by the mid-value.

10. The method for screening the finished antenna PCBs according to claim 9, wherein the step S3 comprises: based on the mid-value, setting a screening threshold for qualified PCBs, measuring resonance points of the other batches of finished antenna PCBs, if the measured resonance points are within the threshold, determining that the measured finished antenna PCBs are qualified.

11. The method for screening the finished antenna PCBs according to claim 10, wherein the threshold is within ±20%.

12. The method for screening the finished antenna PCBs according to claim 9, further comprising the following step after the step S3:
S4: after screening of each batch of PCBs is completed, returning to the step S2 for iterating the mid-value to determine a new mid-value.

13. The method for screening the finished antenna PCBs according to claim 12, wherein for testing the finished antenna PCBs manufactured in the same cycle, the steps S2 to S4 are repeated until screening of all batches of PCBs is completed, and in another cycle of manufacturing the finished antenna PCBs, started from the step S1, the steps S2 to S4 are conducted cyclically.

14. The method for screening the finished antenna PCBs according to claim 9, wherein the method for measuring resonance points in the step S1 comprises: embedding a probe of a measuring device together with the first terminal and the second terminal of the transverse stub into the recess in each short edge of the rectangular shielding ring respectively for connection, and measuring the resonance points of the finished antenna PCBs by the measuring device.
